# EUROPEAN PATENT SPECIFICATION

(11) **EP 0 371 751 B1**
(45) Date of publication and mention of the grant of the patent: **20.09.1995**
(21) Application number: 89312336.4
(22) Date of filing: 28.11.1989
(51) Int. Cl.: H04L 27/20, H04L 27/12

(54) **Digital GMSK modulator with non integer bit interval handling**
Digitaler GMSK-Modulator mit nicht ganzzahliger Bitintervallverarbeitung
Modulateur pour modulation gaussienne par déplacement minimum de fréquence avec traitement des intervalles de bit non entiers

(30) Priority: 30.11.1988 US 278080
(43) Date of publication of application: 06.06.1990
(73) Proprietor: MOTOROLA, INC., Schaumburg, IL 60196 (US)
(72) Inventor: Wang, Chih-Fei, Palatine, Illinois 60067 (US)
(74) Representative: Dunlop, Hugh Christopher

(56) References cited:
- EP-A- 0 169 612
- US-A- 4 562 581
- PATENT ABSTRACTS OF JAPAN, vol. 5, no. 103 (E-64)[775], 3rd July 1981;& JP-A-56 47 153 (TOKYO SHIBAURA DENKI) 28-04-1981
- ELECTRONICS LETTERS, vol. 20, no. 21, 11th October 1984, pages 875-876; H. SUZUKI et al.: " Single-chip baseband waveform generator CMOS-LSI for quadrature-type GMSK modulator "

## Description

### Field of the Invention

The present invention relates generally to radio frequency (RF) circuits, and, more particularly, to RF modulation circuits.

### Background Art

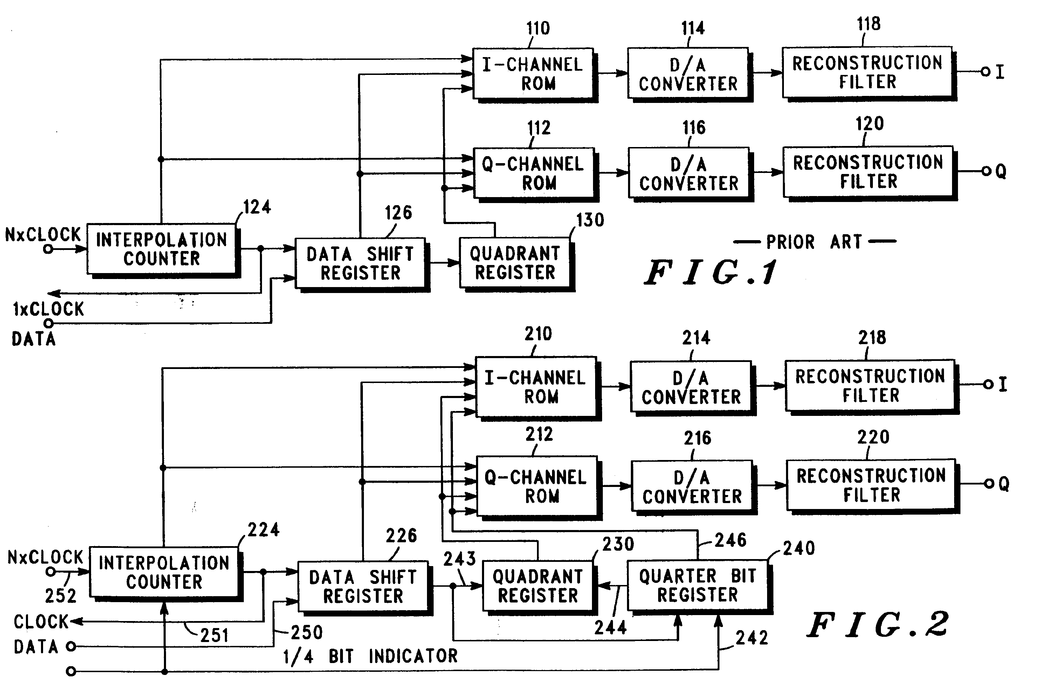

Gaussian Minimum Shift Keying (GMSK) modulation can be generated digitally by employing ROM (read only memory) look-up tables, or a combination of random logic and ROM look-up tables, using digital FIR (Finite Impulse Response) techniques. This is typically accomplished in an RF system by programming two ROMs with data to accommodate FIR filtering functions, one ROM programmed to produce the I channel component and the second ROM programmed to produce the Q channel component of the baseband GMSK signal. Figure 1 illustrates this known approach. For more details on this modulation technique, reference may be made to H. Suzuki et al., "Single-Chip Baseband Waveform Generator CMOS-LSI for Quadrature-Type GMSK Modulator,"Electronic Letters, 11 October 1984, Vol. 20, No. 21, pp. 875-876, which discloses a diagram representative of that shown herein in Figure 1. Additional background information of frequency shift keying, e.g., MSK or GMSK, modulation/demodulation systems may be obtained by referencing U.S. Patents 4,606,051 - Crabtree; 4,414,675 - Comroe; and 4,581,749 - Carney et al., all of which are assigned to Motorola, Inc. References may also be made to M. Simon and C. Wang, "Bit Synchronization of Differentially Detected MSK and GMSK", IEEE International Conference on Communications, June 1985, pp. 583-590; and K. Murota and K. Hirade, "GMSK Modulation for Digital Mobile Radio Telephony", IEEE Transactions on Communications, Vol. COM-29, No. 7, July 1981, pp. 1044-1050. For information on digital phase modulation techniques using ROMs, reference is made to John B. Anderson, Tor Aulin and Carl-Erik Sundberg, "Digital Phase Modulation", Plenum Press, New York, NY, 1986, pp. 211-235.

Such a technique works well with data being clocked out regularly on one bit intervals. However, there are times when the data has to be clocked out for an interval greater than one bit (e.g., 1.25 bits). This may occur, for example, in TDMA (time division multiple access) systems which have time slots which contain a non-integer number of bits.

Theoretically, such a requirement would not cause a splatter in the transmission frequency spectrum since the data rate is lowered at such irregular times. However, the fractional bit interval causes a phase discontinuity in the ROM look-up table output. For this reason, known systems using the approach of Fig. 1 cannot be employed to accommodate such a requirement.

### Summary of the Invention

According to the present invention there is provided a digital modulator for generating angle modulated carriers comprising: a clock circuit, synchronized to an input data signal for producing clock signals; at least one pre-programmed memory device having a content; and a control circuit, controlled by the clock signals, for addressing the pre-programmed memory device in response to the input data signal, to access the pre-programmed memory device content; the digital modulator characterized by: a counter, coupled to the control circuit and controlled by an indicator signal that indicates a non-integer bit interval, for selectively addressing the pre-programmed memory device in response to said indicator signal, whereby the phase continuity of an angle modulated carrier is maintained during non-integer bit modulations.

In a preferred embodiment, the control circuit comprises: an interpolation counter, driven by the clock signals for establishing a data transmission rate and providing memory device address signals to the pre-programmed memory device at the data transmission rate; a data shift register, coupled to the interpolation counter, for receiving the input data signals and providing pre-programmed memory device address signals representing components of a base band modulation signal; and a quadrant register, coupled to and controlled by data shifted out of the data shift register, for providing pre-programmed memory device address signals, representing a phase angle of the input data signals with respect to the clock signals.

In a preferred embodiment, the indicator signal is coupled to the interpolation counter for restarting interpolation counter counting procedures upon receiving an indicator signal, which signal that indicates a non-integer bit interval is transmitted by the input data signal source.

In a further preferred embodiment, the digital modulator comprises a digital-to-analog converter, coupled to the pre-programmed memory device, for receiving pre-programmed memory device content and converting said pre-programmed memory device content into samples of an angle modulated carrier.

The present invention advantageously provides an improved digital modulation technique suitable for digital GMSK or any digital modulation with non-integer bit interval capability.

The present invention may briefly be described in terms of a preferred embodiment. Essentially, a modulation circuit is used in a modulation system substantially synchronized to a system clock. The system includes one or more ROMs, each ROM being pre-programmed as a look-up table for generating a representative digital waveform based on an integer bit interval input data stream and a clock signal. Each digital waveform is converted to an analog signal for subsequent radio frequency (RF) modulation. Each ROM is addressed by an interpolation counter controlled by the clock signal, by a data shift register receiving input data at a rate corresponding to the clock signal, and by a quadrant register, also receiving the input data, for specifying the phase of the data signal with respect to the clock signal. Additionally, a signal that indicates the presence of a non-integer bit interval is provided. In response to this signal, ROM addressing is updated in order to avoid phase discontinuity at the look-up table outputs.

Accordingly, a method for maintaining the phase of a modulated carrier signal based on the introduction of a non-integer bit interval is achieved.

An exemplary embodiment of the present invention will now be described with reference to the accompanying drawings.

### Brief Description of the Drawings

Fig. 1 is a block diagram of a modulation arrangement known in the prior art;
Fig. 2 is a block diagram of a modulation arrangement according to a preferred embodiment of the present invention;
App. A is a C language program useful for generating the contents of the ROMs 210 and 212 of Fig. 2;
App. B is a state diagram representing the operation of the quadrant register 230 of Fig. 2; and
App. C is a state diagram representing the operation of the quadrant bit register 240 of Fig. 2.

### Detailed Description of the Preferred Embodiment

The arrangement disclosed in this specification is directed to GMSK signalling in an RF cellular radiotelephone communication system. More specifically, the instant invention is best used in a digitally generated GMSK signalling technique which allows data to be clocked into the signaling protocol at irregular non-integer intervals, e.g., at one quarter bit intervals.

Fig. 2 illustrates a general block diagram of an arrangement which embodies the instant invention. The arrangement of Figure 2 is similar to the known arrangement of Figure 1, but it includes an improvement to accommodate the signalling protocol at irregular non-integer intervals, as previously discussed. Common to both arrangements of Figures 1 and 2 are conventional 2048-byte ROMs 110/112 and 8192-byte ROMs 210/212, digital to analog (D/A) converters 114/116 and 214/216 such as a TDC1016 available from TWA, Inc., reconstruction filters 118/120 and 218/220 (preferably conventional Bessel low pass filters), interpolation counters 124 and 224 such as a conventional divide-by-N ripple counter, M-bit shift registers 126 and 226 having parallel data output, and quadrant registers 130 and 230 such as conventional 2-bit up/down counter. Unique to the arrangement of Figure 2 is a quarter-bit register 240, its associated 1/4 bit indicator 242 and data 243, its quadrant register output 244 and its ROM address outputs 246.

Preferably, a 2-bit up/down counter is used to implement the quarter-bit register 240.

The operation of the arrangement of Figure 2 will now be discussed in block diagram form using references to conventional counters and shift registers to facilitate discussion. This discussion will be followed with a state operational discussion of the quadrant register 230 and the quarter bit register 240 for more specific explanation.

The I- and Q- channel ROMs 210 and 212 are preprogrammed with data using a C language program, attached as appendix A. This program provides the data for the ROMs to serve four functions: (1) a digital FIR (Finite Impulse Response) filter, (2) and integration process, (3) phase correlation for sine and cosine processing of the I- and Q- channel components of the input data, and (4) NRZ (nonreturn-to-zero) to impulse conversation. Because GMSK modulation can be generated digitally by a digital FIR (Finite Impulse Response) filter, the FIR function is incorporated into the preprogrammed ROM data to approximate the required Gaussian data filter with NRZ data input and the phase angle output. The phase angle output is then used in conjunction with a SIN (sine) and a COS (cosine) portion of the respective ROM look-up tables to generate the I- and Q- channel baseband components in digital form.

The D/A converters 214 and 216 are used to convert the data output from the ROMs 210 and 212 to the I- and Q-channel baseband components in analog. form. Conventional reconstruction filters 218 and 220 are then employed before the quadrature modulation step.

The interpolation counter 224 provides the interpolation filtering (oversampling) control for the ROMs 210 and 212 by addressing the ROMs 210 and 212 using its counter outputs. The interpolation counter 224 is used to ease the reconstruction filter design for anti-aliasing and sinx/x correction. The interpolation counter 224 is driven by a clock signal 252 operating at a rate of N times C, where C is the clock rate at which data is to be transmitted through the system and N is determined so that there is an adequate number of samples to represent a bit. Functioning as a divide-by-N counter, the output of the interpolation counter 251 is a clock signal operating at rate C. This output is connected to the data shift register 226 to clock data 250 therein, and connected to data source circuitry (not shown) so as to provide the rate at which data is to be received by the data shift register 226.

The data shift register 226 receives the data 250 in serial form and provides address signals to the ROMs 210 and 212 according to the program attached in appendix A in order for the ROMs to provide its representation in I- and Q- channel component form. The length of the data shift register 226 is determined to be greater than or equal to the duration of the FIR impulse response. In the illustrated embodiment, the length of the data shift register 226 is 5 bits.

The quadrant register 230 receives the data shifted out of the data shift register 226, and is used to inform the ROMs 210 and 212 of the phase angle of the data 250 for the phase angle calculation in the integration process of the program of appendix A. Because the program integrates in conjunction with the phase angle calculation, the calculation result may go beyond 0 to 360 degrees. Since the GMSK may be viewed as a Gaussian data filter followed by an FSK (frequency shift key) modulation with a modulation index of 0.5, i.e., the phase change due to FSK is always plus or minus 90 degrees at the end of a bit interval, a 2 bit quadrant register is sufficient to represent 1 of the 4 possible quadrants as a result of the integration process. When the energy of a modulation bit ripples through the FIR, the quadrant register 230 is incremented or decremented accordingly and the ROM look-up table can be restarted with a new bit shifted in.

A non-integer bit (functional-bit) register 240, a quarter bit register in the illustrated embodiment, is introduced to handle irregular (unpredicted or aperiodic with respect to the clock rate C) data synchronization. This may occur in systems which require resynchronization for access transmission, e.g., resynchronization to a system clock in a TDMA (time division multiple access) system.

The quarter bit register 240 handles such irregularity by adjusting the addresses of the ROMs which specify the phase of the data signal. More specifically, this is accomplished by coupling the data lead 243 to the up/down port of the counter used to implement the quarter bit register 240, by clocking and enabling the quarter bit register 240 only upon reception of an external quarter bit indicator signal along 242, and by coupling the overflow bit 244 of the register 240 to the up/down port of the quadrant register 230. The 1/4 bit indicator 242 is coupled to the interpolation counter 224 in order to restart its counting process. The restarting of the counting process is necessary in systems which require resynchronization with the such irregular non-integer bit times. The output 246 of the quarter bit register 240 addresses the ROMs 210 and 212 according to the specification of the program of appendix A.

Using 1/4 bit incrementation as an example, a two bit register or counter may be used in the implementation of the quarter-bit register 240.

It should be noted that the data shift register 226 should contain all "1"s or all "0"s before the 1/4 bit indicator activates so that the FIR portion of the circuit is in a steady state mode.

Appendix B illustrates a state diagram of the quadrant register 230. There are four states which represent this operation and 3 conditions to which the states react. Each state represents a steady state condition of the quadrant register 230. Condition "A" occurs when the output of the data shift register is high and the interpolation counter 224 has reached 15 (counting from 0 to 15); or the output of the data shift register is high and the outputs of the quarter bit register 240 represent "3" (highest count from 0 to 3 of a 2 bit counter) and the 1/4 bit indicator 242 is high. Condition "B" occurs when the output of the data shift register is low and the interpolation counter 224 has reached 15 (counting from 0 to 15); or the output of the data shift register is low and the outputs of the quarter bit register 240 represent "0" (lowest count from 0 to 3 of a 2 bit counter) and the 1/4 bit indicator 242 is high. The "else" condition represents all other conditions.

Appendix C illustrates a state diagram of the quarter bit register 240. There are four states which represent this operation and 3 conditions to which the states react. Each state represents a steady state condition of the quarter bit register 240. Condition "A" occurs when the output of the data shift register is high and the 1/4 bit indicator 242 is high. Condition "B" occurs when the output of the data shift register is low and the 1/4 bit indicator 242 is high. The "else" condition represents all other conditions.

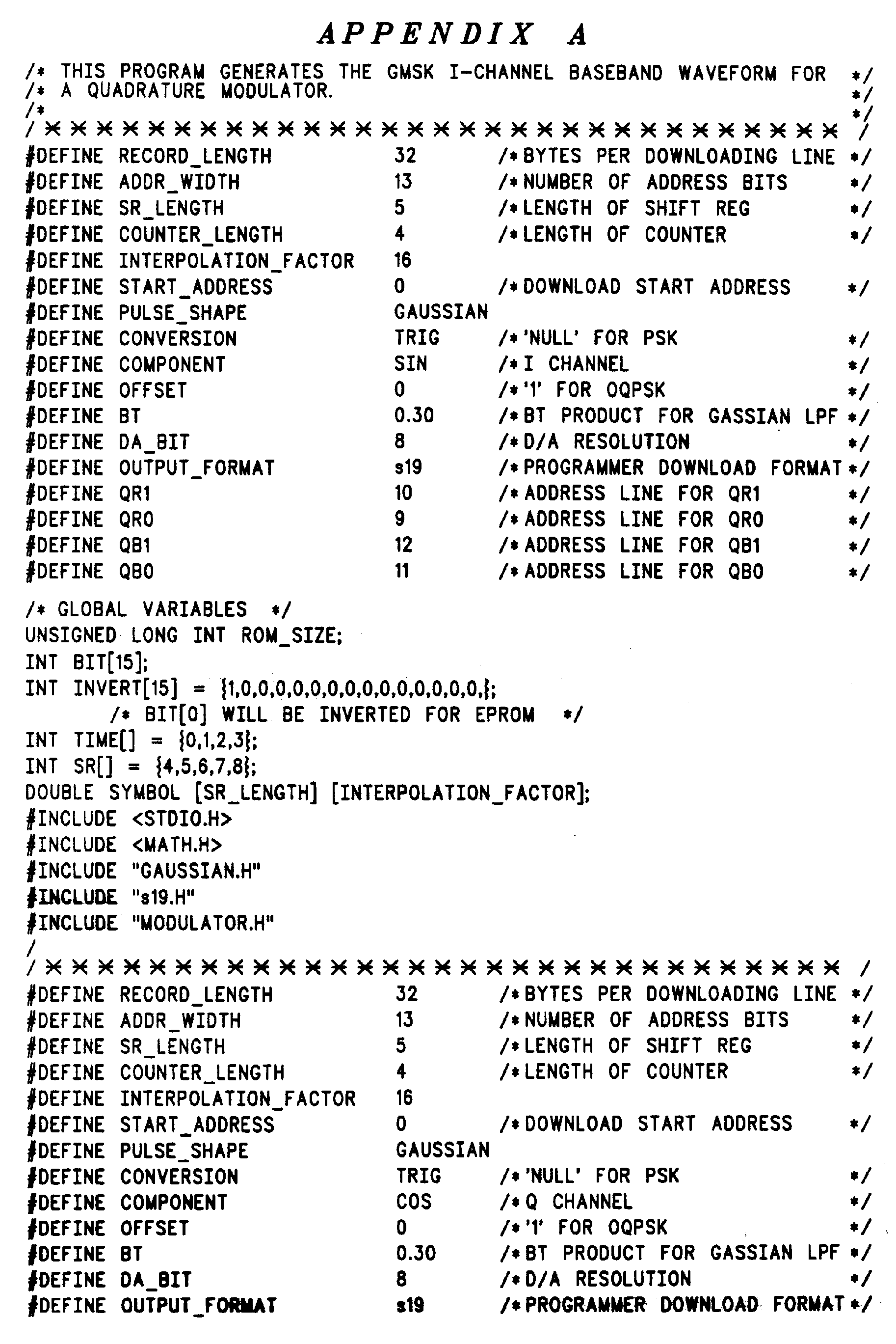

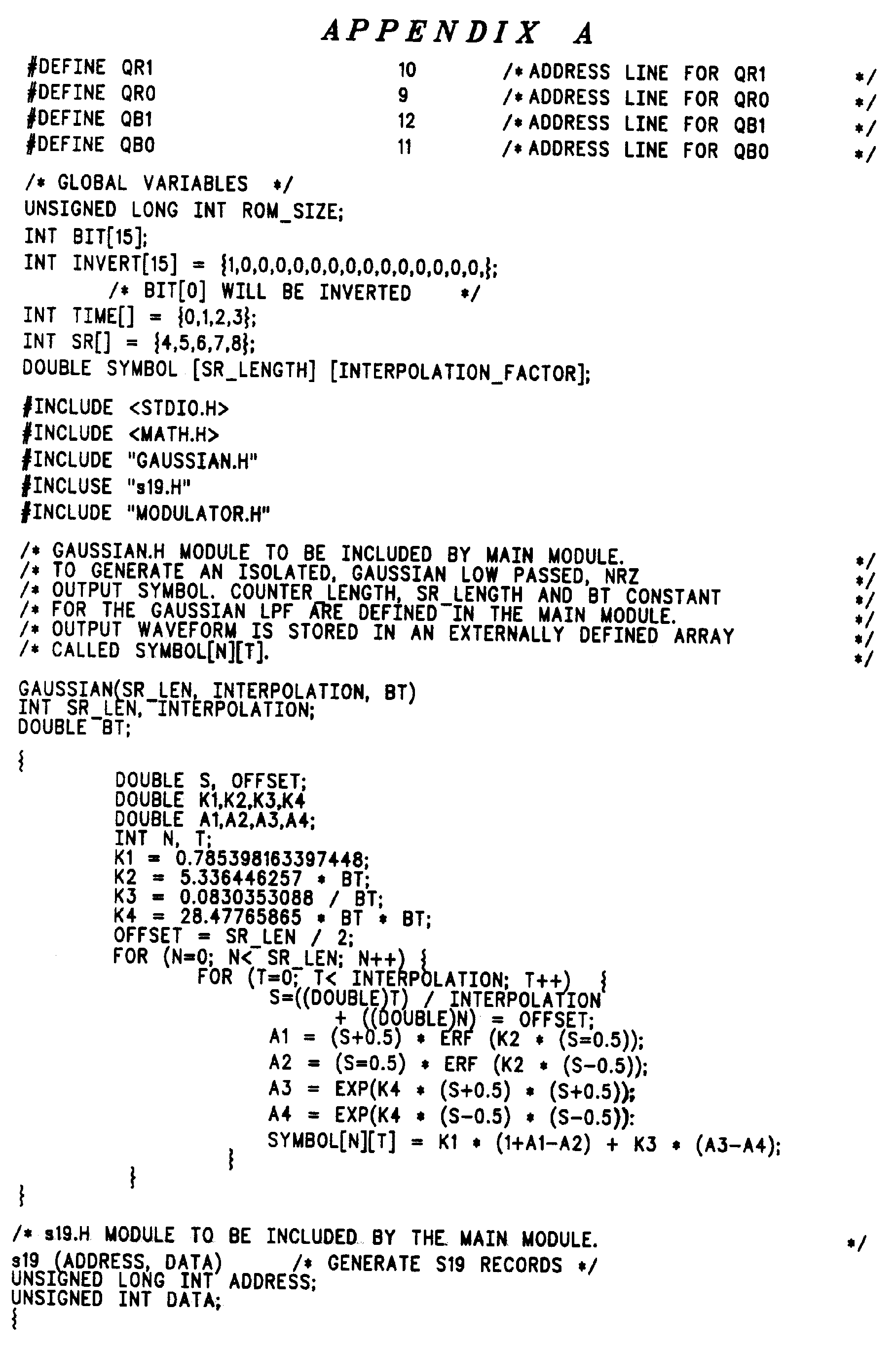

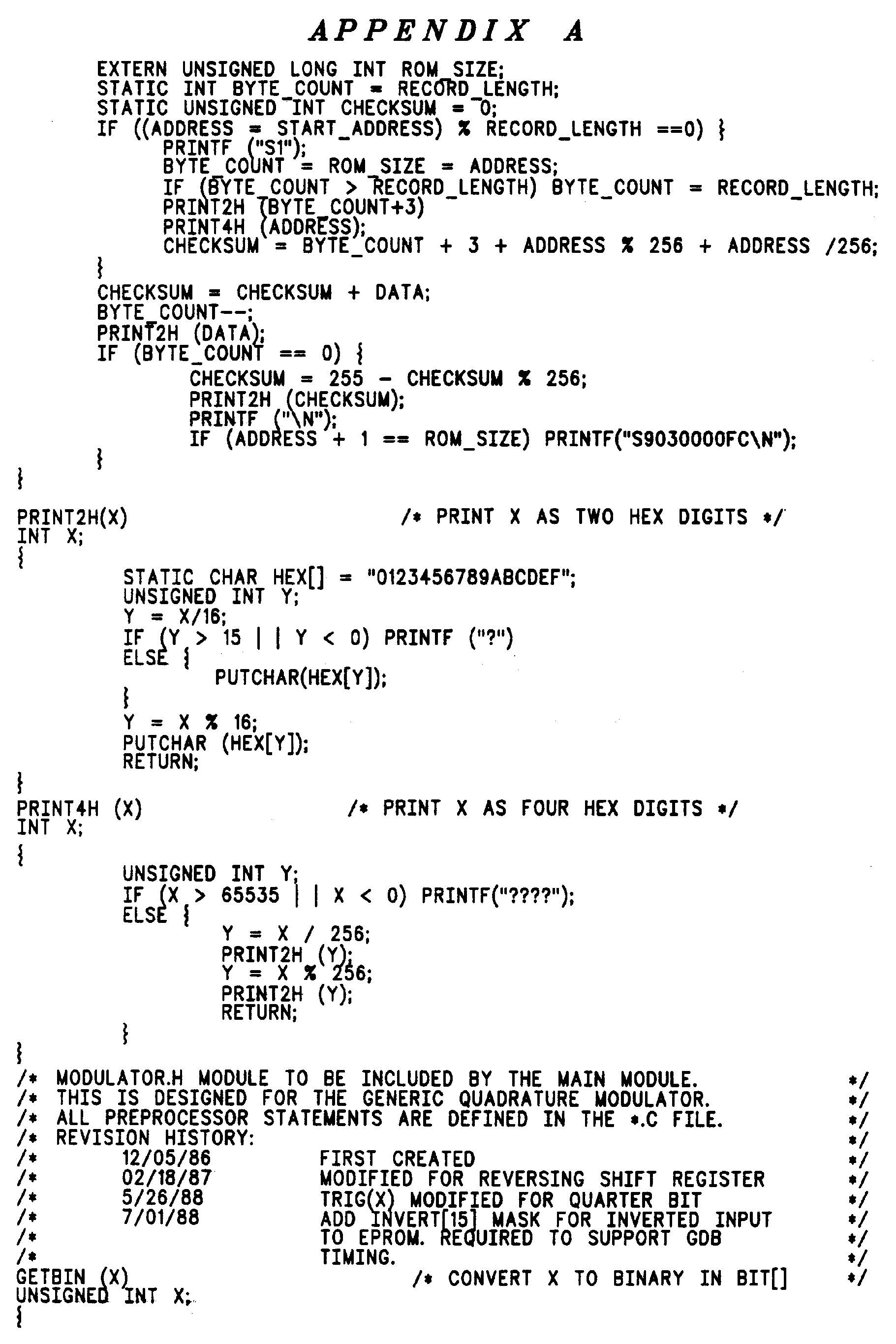

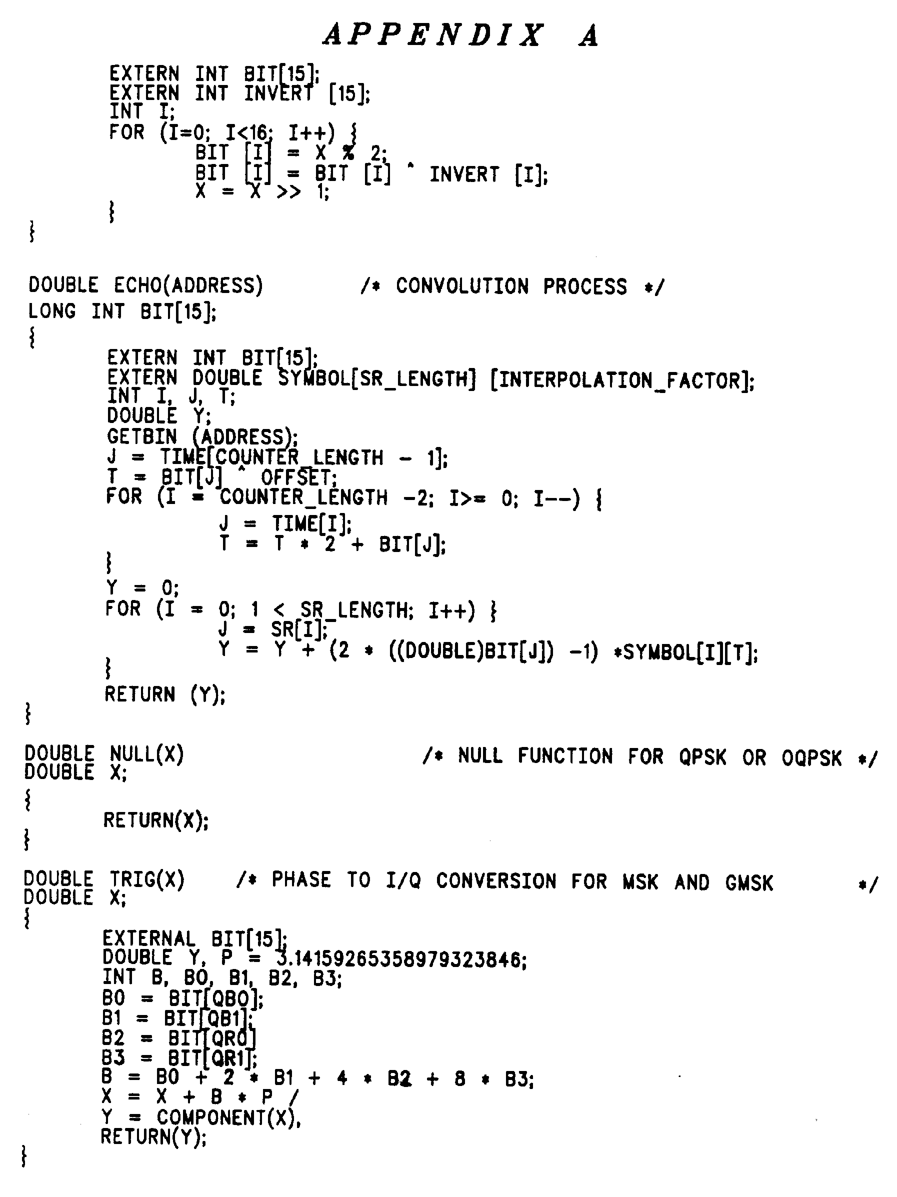

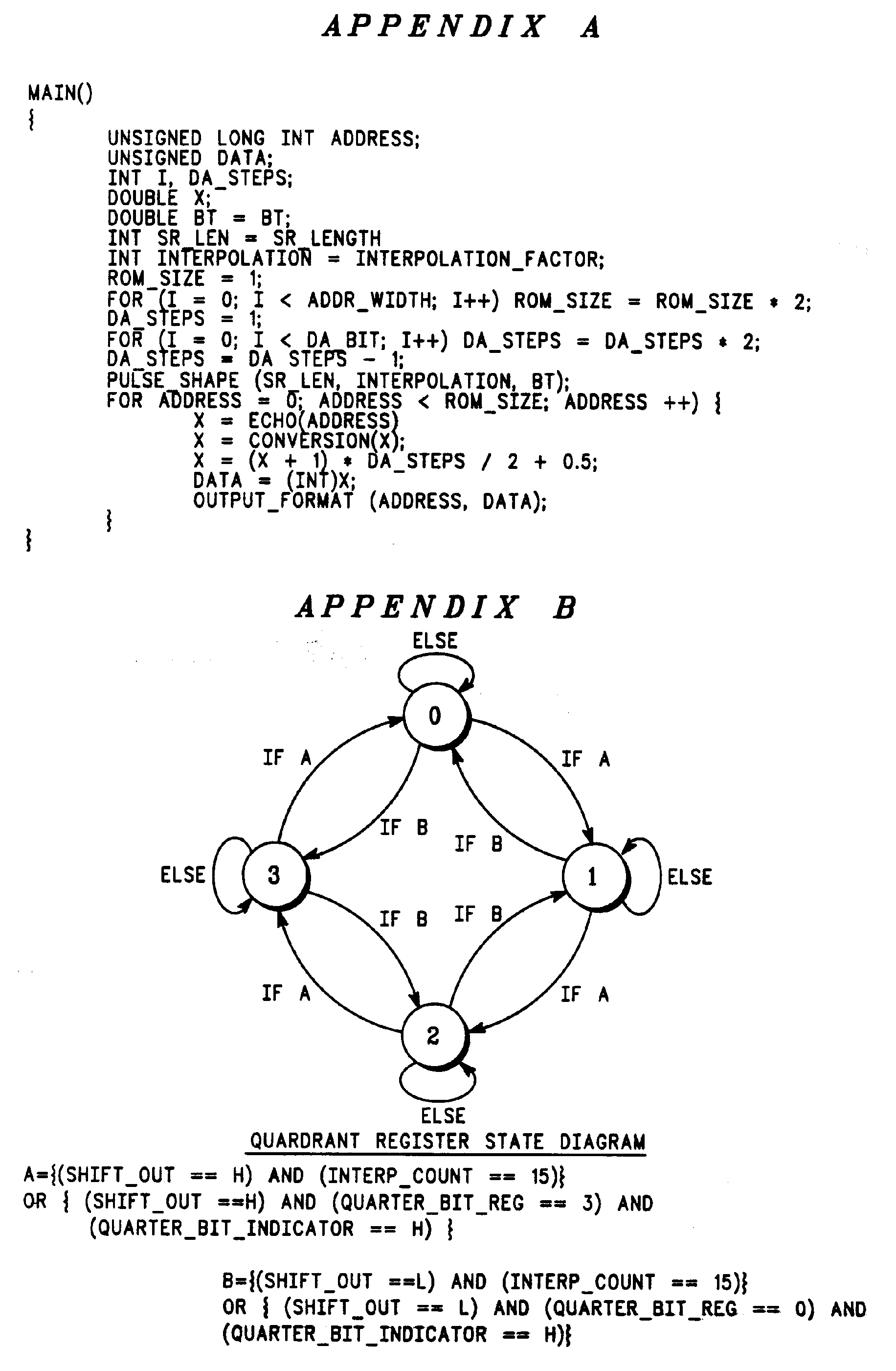

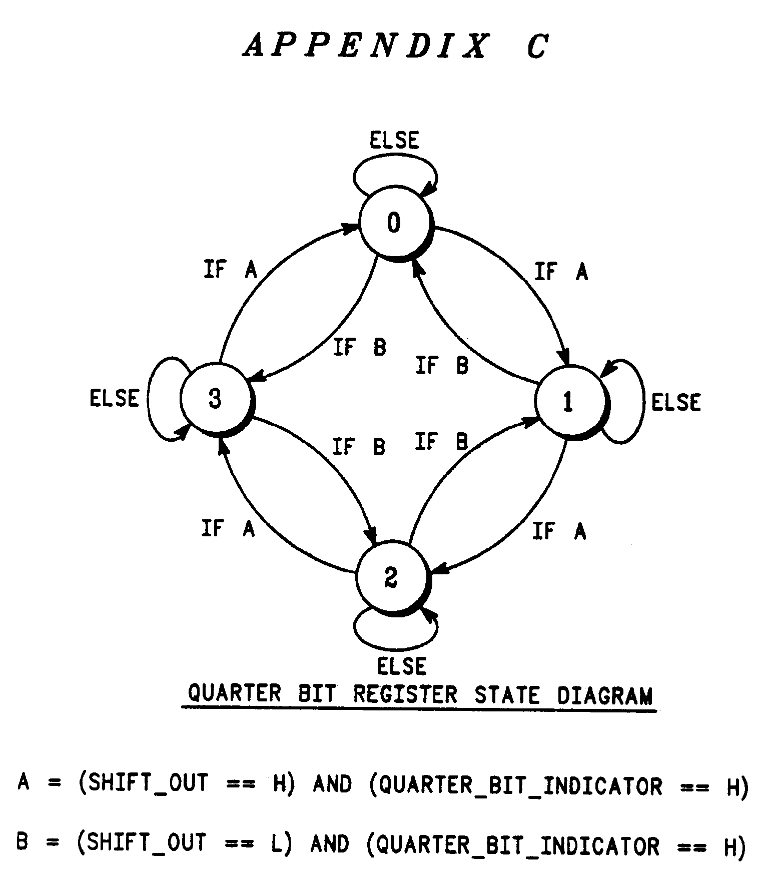

## Claims

1. A digital modulator for generating angle modulated carriers comprising:
a clock circuit, synchronized to an input data signal (250) for producing clock signals (252);
at least one pre-programmed memory device (210) having a content; and
a control circuit, controlled by the clock signals, for addressing the pre-programmed memory device in response to the input data signal, to access the pre-programmed memory device content;
the digital modulator characterized by:
a counter (240), coupled to the control circuit and controlled by an indicator signal (242) that indicates a non-integer bit interval, for selectively addressing the pre-programmed memory device in response to said indicator signal, whereby the phase continuity of an angle modulated carrier is maintained during non-integer bit modulations.

2. The digital modulator according to claim 1, wherein the control circuit comprises:
an interpolation counter (224), driven by the clock signals (252) for establishing a data transmission rate and providing memory device address signals to the pre-programmed memory device at the data transmission rate;
a data shift register (226), coupled to the interpolation counter, for receiving the input data signals and providing pre-programmed memory device address signals representing components of a base band modulation signal; and
a quadrant register (230), coupled to and controlled by data shifted out of the data shift register, for providing pre-programmed memory device address signals, representing a phase angle of the input data signals with respect to the clock signals.

3. The digital modulator according to claim 2, wherein the quadrant register (230) is a 2-bit up/down counter.

4. The digital modulator according to claim 2 or 3, wherein the interpolation counter (224) is a divide-by-N ripple counter.

5. The digital modulator according to claim 2, 3 or 4, wherein the data shift register (226) is an M-bit shift register.

6. The digital modulator according to any one of claims 2 to 5, wherein the indicator signal (242) is coupled to the interpolation counter (224) for restarting interpolation counter counting procedures upon receiving an indicator signal.

7. The digital modulator according to claim 6, wherein the indicator signal that indicates a non-integer bit interval is transmitted by the input data signal source.

8. The digital modulator according to any preceding claim, further comprising:
a digital-to-analog converter, coupled to the pre-programmed memory device (210), for receiving pre-programmed memory device content and converting said pre-programmed memory device content into samples of an angle modulated carrier.

9. The digital modulator according to any preceding claim, wherein the counter is a 2-bit up/down counter.

## Patentansprüche

1. Digitaler Modulator zur Erzeugung winkelmodulierter Träger, der aufweist:
einen Taktschaltkreis, der mit einem Eingangsdatensignal (250) zur Erzeugung von Taktsignalen (252) synchronisiert ist;
mindestens eine vorprogrammierte Speichervorrichtung (210), die einen Inhalt besitzt; und
einen Steuerschaltkreis, der durch die Taktsignale zum Adressieren der vorprogrammierten Speichervorrichtung in Abhängigkeit des Eingangsdatensignals gesteuert wird, um auf den vorprogrammierten Speichervorrichtungsinhalt zuzugreifen;
wobei der digitale Modulator gekennzeichnet ist durch:
einen Zähler (240), der mit dem Steuerschaltkreis verbunden und durch ein Indikatorsignal (242) gesteuert wird, das ein nicht ganzzahliges Bit-Intervall zur selektiven Adressierung der vorprogrammierten Speichervorrichtung in Abhängigkeit des Indikatorsignals anzeigt, wodurch die Phasenkontinuität eines winkelmodulierten Trägers während nicht ganzzahliger Bit-Modulationen beibehalten wird.

2. Digitaler Modulator nach Anspruch 1, wobei der Steuerschaltkreis aufweist:
einen Interpolationszähler (224), der durch die Taktsignale (252) zur Einrichtung einer Datenübertragungsrate und zur Bildung von Speichervorrichtungs-Adress-Signalen zu der vorprogrammierten Speichervorrichtung unter der Datenübertragungsrate angesteuert wird;
ein Datenschieberegister (226), das mit dem Interpolationszähler zum Empfangen der Eingangsdatensignale und zum Liefern vorprogrammierter Speichervorrichtungs-Adress-Signale, die Komponenten eines Basisbandmodulationssignals darstellen, verbunden ist; und
ein Quadrant-Register (230), das verbunden ist mit und gesteuert wird durch Daten, die aus dem Datenschieberegister geschoben sind, und zwar zum Liefern vorprogrammierter Speichervorrichtungs-Adress-Signale, die einen Phasenwinkel der Eingangssignale hinsichtlich der Taktsignale darstellen.

3. Digitaler Modulator nach Anspruch 2, wobei das Quadrant-Register (230) ein 2-Bit-Aufwärts/Abwärts-Zähler ist.

4. Digitaler Modulator nach Anspruch 2 oder 3, wobei der Interpolations-Zähler (224) ein durch N teilender Welligkeits-Zähler ist.

5. Digitaler Modulator nach Anspruch 2, 3 oder 4, wobei das Datenschieberegister (226) ein M-Bit-Schieberegister ist.

6. Digitaler Modulator nach einem der Ansprüche 2 bis 5, wobei das Indikatorsignal (242) mit dem Interpolationszähler (224) zum Wiederstarten des Interpolationszählers, der Prozeduren unter Empfang eines Indikatorsignals zählt, verbunden ist.

7. Digitaler Modulator nach Anspruch 6, wobei das Indikatorsignal, das ein nicht ganzzahliges Bit-Intervall anzeigt, durch die Eingangsdatensignalquelle übertragen wird.

8. Digitaler Modulator nach einem der vorhergehenden Ansprüche, der weiterhin aufweist:
einen Digital-Analog-Wandler, der mit der vorprogrammierten Speichervorrichtung (210) zum Empfangen eines vorprogrammierten Speichervorrichtungsinhalts und zum Konvertieren des vorprogrammierten Speichervorrichtungsinhalts in Abtastungen eines winkelmodulierten Trägers verbunden ist.

9. Digitaler Modulator nach einem der vorhergehenden Ansprüche, wobei der Zähler ein 2-Bit-Aufwärts/Abwärts-Zähler ist.

## Revendications

1. Modulateur numérique destiné à générer des porteuses à modulation angulaire, comprenant :
un circuit d'horloge synchronisé avec un signal de données d'entrée (250) pour produire des signaux d'horloge (252) ;
au moins un dispositif à mémoire pré-programmée (210) ayant un contenu ; et
un circuit de commande, commandé par les signaux d'horloge, pour adresser le dispositif à mémoire pré-programmée en réponse au signal de données d'entrée, pour accéder au contenu du dispositif à mémoire pré-programmée ;
le modulateur numérique étant caractérisé par :
un compteur (240), couplé au circuit de commande et commandé par un signal indicateur (242) qui indique un intervalle de bit non entier, pour adresser sélectivement le dispositif à mémoire pré-programmée en réponse audit signal indicateur, la continuité de phase d'une porteuse à modulation angulaire étant maintenue pendant les modulations de bits non entiers.

2. Modulateur numérique suivant la revendication 1, dans lequel le circuit de commande comprend :
un compteur à interpolation (224) entraîné par les signaux d'horloge (252) pour établir une vitesse de transmission des données et fournir des signaux d'adresse du dispositif à mémoire au dispositif à mémoire pré-programmée à la vitesse de transmission des données ;
un registre de données à décalage (226), couplé au compteur à interpolation, destiné à recevoir les signaux de données d'entrée et à fournir des signaux d'adresse du dispositif à mémoire pré-programmée représentant des composantes d'un signal de modulation en bande de base ; et
un registre à quadrants (230), couplé à et commandé par des données décalées hors du registre de données à décalage, destiné à fournir des signaux d'adresse du dispositif à mémoire pré-programmée, représentant un angle de phase des signaux de données d'entrée par rapport aux signaux d'horloge.

3. Modulateur numérique suivant la revendication 2, dans lequel le registre à quadrants (230) est un compteur progressif/dégressif à 2 bits.

4. Modulateur numérique suivant la revendication 2 ou 3, dans lequel le compteur à interpolation (224) est un compteur en cascade de division par N.

5. Modulateur numérique suivant la revendication 2, 3 ou 4, dans lequel le registre de données à décalage (226) est un registre à décalage à N bits.

6. Modulateur numérique suivant l'une des revendications 2 à 5, dans lequel le signal indicateur (242) est couplé au compteur à interpolation (224) pour relancer les procédures de comptage du compteur à interpolation à la réception d'un signal indicateur.

7. Modulateur numérique suivant la revendication 6, dans lequel le signal indicateur qui indique un intervalle de bit non entier est transmis par la source de signaux de données d'entrée.

8. Modulateur numérique suivant l'une des revendications précédentes, comprenant en outre :
un convertisseur numérique-analogique, couplé au dispositif à mémoire pré-programmée (210), destiné à recevoir le contenu du dispositif à mémoire pré-programmée et à convertir ledit contenu du dispositif à mémoire pré-programmée en échantillons d'une porteuse à modulation angulaire.

9. Modulateur numérique suivant l'une des revendications précédentes, dans lequel le compteur est un compteur progressif/régressif à 2 bits.
